# EUROPEAN PATENT APPLICATION

(11) **EP 4 509 638 A1**
(43) Date of publication of application: **19.02.2025**
(21) Application number: 22942199.5
(22) Date of filing: 27.05.2022
(51) Int. Cl.: C23C 16/448, H01L 21/673, F17C 9/02, F17C 13/00

(54) **SOLID-STATE SOURCE GASIFICATION DEVICE**

(30) Priority: 18.05.2022 CN 202210547408
(71) Applicant: Jiangsu Nata Opto-Electronic Material Co., Ltd, Suzhou, Jiangsu 215000 (CN)
(72) Inventor: YANG, Min, Suzhou, Jiangsu 215000 (CN); SHEN, Bin, Suzhou, Jiangsu 215000 (CN)
(74) Representative: Ipside
(86) International application number: PCT/CN2022/095627
(87) International publication number: WO 2023/221164

(57) **Abstract**

The present invention discloses a solid-state source gasification device, comprising a housing and one or more trays, a top cover is provided on the top of the housing. A gas inlet and a gas outlet are provided on the top cover. The trays are vertically stacked in the housing. A carrier gas pipe is provided in the housing. An upper end of the carrier gas pipe is connected to the gas inlet. The carrier gas pipe penetrates through the trays, and extends into the bottommost-layer tray. One or more carrier gas outlets are formed in the carrier gas pipe. The carrier gas outlets are formed in a space of the bottommost-layer tray or formed in a space of the bottommost-layer tray and the rest trays. Except for the bottommost-layer tray, the rest trays are each provided with one or more gas conduits. The solid-state source gasification device of the present invention adopts a parallel gas transmission channel, whereby the carrier gas, after entering the carrier gas pipe from the gas inlet, can enter into each tray separately, and can be transmitted horizontally in each tray along the surface of the solid-state source material for a longer distance before reaching gas conduit, and thus a large amount of gasification gas can be carried in the carrier gas to enhance the overall gasification efficiency of the solid-state source gasification device.

## Description

### Technical Field

The present invention relates to the field of a solid-state source gasification device, and more particularly to a solid-state source gasification device for vaporizing solid precursor materials, so as to deliver precursor vapors to a reaction cavity of a precursor vapor-using system, such as a chemical vapor deposition apparatus, an atomic deposition apparatus, or an ion implantation apparatus..

### Background of the Invention

Traditional solid-source gasification devices usually have one or more trays inside a sealed container for placing solid feedstock. In the case of several trays, each tray is provided with several gas conduits to connect the trays. In the operating condition, the sealed container is externally heated to a gasification temperature of the solid feedstock. The sealed container has a gas inlet for carrier gas to pass through. The carrier gas is thoroughly mixed with the vapors of the solid feedstock and is fed by the gas outlet into the reaction cavity connected to the solid-source gasification device. The typical carrier gas is an inert gas such as helium. In semiconductor manufacturing applications, the reaction container is usually a reaction cavity of thin film deposition equipment, such as CVD, ALD equipment. In the traditional solid-state source gasification device, the carrier gas enters the vessel from the top or the bottom and is transferred to the bottom of the housing through a gas conduit. The carrier gas then rises layer by layer through the gas conduit on each tray. During the ascent, the carrier gas is mixed with the vapors vaporized by the solid-state source, and the mixed gas is output from the gas outlet at the top and transported to a reaction container.

The disadvantages of the traditional solid-state source gasification device lie in that: firstly, the prior technology employs a parallel gas transmission channel, and the carrier gas has to pass through the gas conduit from the bottom up into each tray in turn. Then the carrier gas finally reaches the uppermost-layer tray, and is outputted from the gas outlet, so that the carrier gas has a low vapor content when it enters into the trays on the lower layers. As a result, the gasification speed of the solid feedstock in the lower-layer trays is relatively fast. And when the carrier gas reaches the trays in the top layers, the concentration of the vapors carried in the carrier gas is relatively high. Therefore, the gasification speed of the solid feedstock in the upper trays will be slower, resulting in a large difference in the gasification speed of the solid feedstock between the bottom-layer tray and the upper-layer tray within the solid-source gasification device, and the solid feedstock of the upper layers will not be able to be fully utilized. Secondly, since a plurality of gas conduits are uniformly distributed in each tray, in order to prevent solid feedstock particles from entering into the gas conduits and causing blockage of the gas conduits, the height of the gas conduits is higher than the loading height of the solid feedstock in the trays. The loading of the solid feedstock is usually high, so the height of the gas conduits is usually close to the epitaxial height of the trays, resulting in the top of the ventilating gas conduits being very close to the bottom of the trays on which are stacked. And thus, the flow distance of the carrier gas stream on the surface of the solid feedstock is very short, and so the amount of solid source vapors that can be carried by the carrier gas is very small, resulting in a very low mixing efficiency of the carrier gas with the vapors. In addition, although the traditional solid-state source gasification device is provided with multiple-layers trays, and the total surface area of the solid feedstock loaded in the trays is large, the gasification efficiency of the upper layers is not maximized, and the total gasification efficiency and transfer efficiency are not optimized. Thus, there is a need to increase the traditional solid-state source gasification device.

### Summary of the Invention

The purpose of the present invention is to provide a new type of solid-state source gasification device in response to the problems of the traditional solid-state source gasification device in the background technology. The traditional solid-state source gasification device adopts a parallel gas transmission channel, in which the gasification efficiency of the solid-state source material in the upper-layer tray is very low. The carrier gas in each tray has a very short horizontal travel distance, and thus has a poor mixing effect with the solid-state source vapors. And the amount of vapors which can be carried by the carrier gas is very small. The overall gasification efficiency and transmission efficiency of the solid-state source gasification device is very low, and so on.

To achieve the foregoing objects, a first realization of the present invention is as follows: a solid-state source gasification device comprises a housing and several trays, a top cover is provided on the top of the housing, a gas inlet and a gas outlet are provided on the top cover, the trays are vertically stacked in the housing, a carrier gas pipe is provided in the housing, an upper end of the carrier gas pipe is connected with the gas inlet, the carrier gas pipe penetrates through each tray and extends to the bottommost-layer tray, one or more carrier gas outlets are provided in the carrier gas pipe, and carrier gas outlets are formed in a space of the bottommost-layer tray or formed in a space of the bottommost-layer tray and the rest trays, and one or more gas conduits are formed in all trays except the bottommost-layer tray.

As a further improvement, the gas conduits are arranged away from the carrier gas pipe. With this arrangment, the position of the carrier gas entering the tray is far away from the position of the gas conduit, so that the carrier gas, after entering the trays, has to pass through a longer path before reaching the position of the gas conduit of the upper tray, and rises up to the upper tray through the gas conduit. In this way, the carrier gas can fully mix with the vapors generated by the vaporization of the solid source on the tray in the flow process, and carry a large amount of vapors into the upper tray, so as to increase the rate of vaporization of the solid source material in the tray and the efficiency of the transportation of the vapors.

As a further improvement, the carrier gas pipe is arranged off-center with respect to the tray. A distance between the carrier gas pipe and the gas conduit can be further increased by this setting. In the flow process, the carrier gas can be fully mixed with the vapors generated by the vaporization of the solid source on the tray and carry a large amount of vapors into the upper tray, so as to increase the vaporization rate of the solid source material in the tray and the efficiency of the transportation of the vapors.

As a further improvement, the gas conduits in adjacent trays are spaced apart at a set distance. With this arrangment, it is possible to make the gas mixture rising to the upper tray pass a transmission distance within the trays before being able to enter the gas conduit of the tray on further layer and rise up to the further tray, which further increases the mixing efficiency of the gas mixture with the solid-state source vapors.

As a further improvement, each tray is provided with several gas conduits . The gas conduits are arranged away from the carrier gas pipe. With this arrangment, the transmission efficiency of the gas mixture can be increased.

A second realization of the present invention is as follows: a solid-state source gasification device comprises a housing and several trays, a top cover is provided on the top of the housing, a gas outlet is provided on the top cover, the trays are vertically stacked in the housing, a gas inlet is provided at the bottom of the housing, a carrier gas pipe is provided in the housing, an upper end of the carrier gas pipe is connected with the gas inlet, the carrier gas pipe penetrates through the trays of the various layers and extends to the bottommost-layer tray, one or more carrier gas outlets are provided in the carrier gas pipe, and carrier gas outlets are formed in a space of the bottommost-layer tray or formed in a space of the bottommost-layer tray and the rest trays, and one or more gas conduits are formed in all trays except the bottommost-layer tray.

As a further improvement, the gas conduits are arranged away from the carrier gas pipe. With this arrangment, the position of the carrier gas entering the tray is far away from the position of the gas conduit. After entering the tray, the carrier gas has to pass through a longer path before reaching the position of the gas conduit of the upper tray, and rises up to the upper tray through the gas conduit. In this way, the carrier gas can fully mix with the vapors generated by the vaporization of the solid source on the tray in the flow process, and carry a large amount of vapors into the upper tray, so as to increase the rate of vaporization of the solid source material in the tray and the efficiency of the transportation of the vapors.

As a further improvement, the carrier gas pipe is arranged off-center with respect to the tray. A distance between the carrier gas pipe and the gas conduit can be further increased. By this setting, the carrier gas, in the flow process, can be fully mixed with the vapors generated by the vaporization of the solid source on the tray and carry a large amount of vapors into the upper tray, so as to increase the vaporization rate of the solid source material in the tray and the efficiency of the transportation of the vapors.

As a further improvement, the gas conduits in adjacent trays are spaced apart at a set distance. With this arrangment, it is possible to make the gas mixture rising to the the upper tray pass a transmission distance within the trays before being able to enter the gas conduit of the tray on upper layer and rise up to the upper tray, which further increases the mixing efficiency of the gas mixture with the solid-state source vapors.

As a further improvement, each tray is provided with several gas conduits. The gas conduits being arranged away from the carrier gas pipe. With this arrangment, the transmission efficiency of the gas mixture can be increased.

A third realization of the present invention is as follows: a solid-state source gasification device comprises a housing and several trays, a top cover is provided on the top of the housing, a gas inlet and a gas outlet are provided on the top cover, the trays are vertically stacked in the housing, a first carrier gas pipe and a second carrier gas pipe are provided in the housing, an upper of the first carrier gas pipe is connected to a gas inlet, the first carrier gas pipe penetrates through the trays and extends into a space of the bottommost-layer tray, there are several second carrier gas pipes, the second carrier gas pipes penetrates through the trays from the bottom up, a lower openning of the second carrier gas pipe is arranged in the space under the bottommost-layer tray, and there are one or more gas outlets provided in the second carrier gas pipes, the carrier gas outlets are provided in the space of the bottommost-layer tray or in the spaces of the bottommost-layer tray and the rest of the trays, and one or more gas conduits are formed in all trays except the bottommost-layer tray.

As a further improvement, the first carrier gas pipe is formed at a central position of the tray or at a position arranged off-center with respect to the tray. The first carrier gas pipe can be formed at a central position of the tray or at a position arranged off-center with respect to the tray, and the arrangment can be flexibly adjusted according to the needs of the airflow path.

As a further improvement, the second carrier gas pipe is formed at a central position of the tray or at a position arranged off-center with respect to the tray. The second carrier gas pipe can be formed at a central position of the tray or at a position arranged off-center with respect to the tray, and the arrangment can be flexibly adjusted according to the needs of the airflow path.

As a further improvement, the second carrier gas pipe is arranged away from the first carrier gas pipe. This arrangment enables the carrier gas to enter the carrier gas pipe after the space underneath the bottommost-layer tray is filled , making the pressure of the carrier gas more stable.

As a further improvement, the gas conduit is arranged away from the second carrier gas pipe. With this arrangment, the position of the carrier gas entering the tray is far away from the position of the gas conduit. The carrier gas, after entering the tray, has to pass through a longer path before reaching the position of the gas conduit of the upper tray, and rises up to the upper tray through the gas conduit. In this way, the carrier gas can fully mix with the vapors generated by the vaporization of the solid source on the tray in the flow process, and carry a large amount of vapors into the upper tray, so as to increase the rate of vaporization of the solid source material in the tray and the efficiency of the transportation of the vapors.

As a further improvement, the gas conduits in adjacent trays are spaced apart at a set distance. With this arrangment, it is possible to make the gas mixture rising to the the upper tray pass a transmission distance within the trays before being able to enter the gas conduit of the upper tray and rise up to the upper tray, which further increases the mixing efficiency of the gas mixture with the vapors.

As a further improvement, the tray is provided with a plurality of gas conduits. With this arrangment, the transmission efficiency of the gas mixture can be increased.

As a further improvement, the tray is provided with a plurality of gas conduits and the gas conduits are provided in the vicinity of the first carrier gas pipe. With this arrangment, the transmission efficiency of the gas mixture can be increased, and the gas conduit can be kept away from the second carrier gas pipe to increase the mixing efficiency of the carrier gas and the vapors.

As a further improvement, the first carrier gas pipe is also provided with gas outlet openings at corresponding positions in the spaces of one or more trays. This arrangment enables a small amount of carrier gas to enter the tray through the gas outlet opening on the first carrier gas pipe and to mix with the vapors produced by the vaporization of the solid-state source in the tray, increasing the mixing efficiency.

As a further improvement, there is one or more the second carrier gas pipes. When only one second carrier gas pipe is provided, the carrier gas enters the tray through the carrier gas outlet on the second carrier gas pipe. When a plurality of second carrier gas pipes are provided, the transfer efficiency of the carrier gas can be increased, which in turn increases the gas transfer efficiency within the solid-state source gasification device.

The present invention has positive effects: 1) The solid-state source gasification device of the present invention adopts a parallel gas transmission channel, and the carrier gas, after entering the carrier gas pipe from the gas inlet, is able to enter into each tray separately. The carrier gas, after entering into each tray, is able to be transmitted horizontally along the surface of the solid-state source substance in each tray for a long distance before it arrives at the position of the gas conduit, and thus a large amount of the solid-state source vapors is able to be carried in the carrier gas. 2) Because the carrier gas input in each tray is a carrier gas that does not contain volatile gases, the amount of vapors that the carrier gas can carry is large, and it can make the gasification rate of the solid source material in each tray similar, increase the gasification efficiency of the solid source material in each tray, and thus increase the overall gasification efficiency of the solid-source gasification device.

### Brief Description of the Drawings

FIG. 1a shows a schematic structure of the solid-state source gasification device of Example 1.
FIG. 1b shows a top view schematic diagram of the solid-state source gasification device of Example 1.
FIG. 1c shows a schematic diagram of the A-A sectional view of FIG. 1b.
FIG. 1d shows an internal structure of the solid-state source gasification device of Example 1.
FIG. 1e shows a schematic diagram of the structure of the first-layer tray to third-layer tray.
FIG. 1f shows a B-B sectional view of FIG. 1e.
FIG. 1g shows a schematic structure of the forth-layer tray.
FIG. 1h shows a C-C sectional view of FIG. 1g.
FIG. 2a shows a schematic structure of the solid-state source gasification device of Example 2.
FIG. 2b shows a top view schematic diagram of the solid-state source gasification device of Example 2.
FIG. 2c shows a schematic diagram of the D-D sectional view of FIG. 2b.
FIG. 2d shows a schematic diagram of the internal structure of the solid-state source gasification device of Example 2.
FIG. 3a shows a schematic structure of the solid-state source gasification device of Example 3.
FIG. 3b shows a top view schematic diagram of the solid-state source gasification device of Example 3.
FIG. 3c shows a schematic E-E sectional view of FIG. 3b.
FIG. 3d shows a schematic diagram of the internal structure of the solid-state source gasification device of Example 3.
FIG. 4a shows a schematic structure of the solid-state source gasification device of Example 4.
FIG. 4b shows a top view schematic diagram of the solid-state source gasification device of Example 4.
FIG. 4c shows a schematic diagram of the F-F sectional view of FIG. 4b.
FIG. 4d shows a schematic diagram of the internal structure of the solid-state source gasification device of Example 4.
FIG. 5a shows a schematic structure of the solid-state source gasification device of Example 5.
FIG. 5b shows a top view schematic diagram of the solid-state source gasification device of Example 5.
FIG. 5c is a schematic diagram of the G-G sectional view of FIG. 5b.
FIG. 5d shows a schematic diagram of the internal structure of the solid-state source gasification device of Example 5.
FIG. 6a shows a schematic structure of the solid-state source gasification device of Example 8.
FIG. 6b shows a top view schematic diagram of the solid-state source gasification device of Example 8.
FIG. 6c is a schematic K-K sectional view of FIG. 6b.

### Detailed Description of Embodiments

The following is a clear and complete description of the technical solution of the present invention by means of embodiments, and it is obvious that the described embodiments are only a part of the embodiments of the present invention and not all of the embodiments. Based on the embodiments in the present invention, all other embodiments obtained by the person of ordinary skill in the field without making creative labor are within the scope of protection of the present invention.

### Example 1

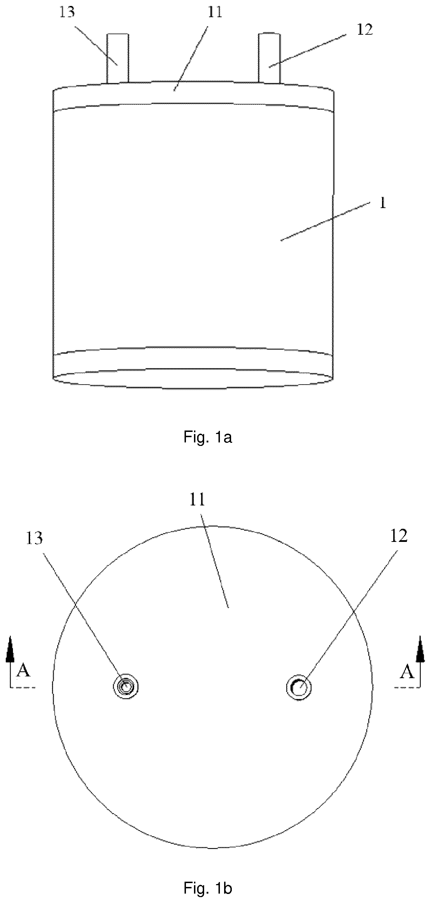

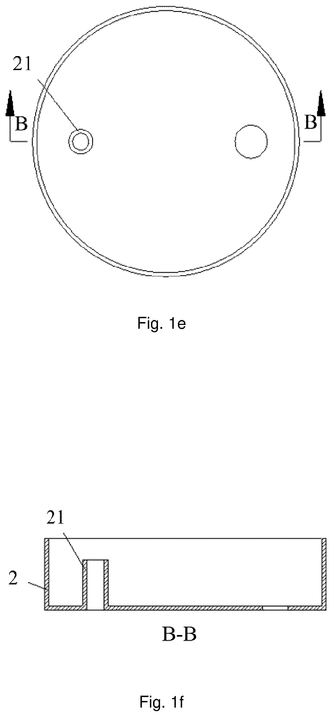

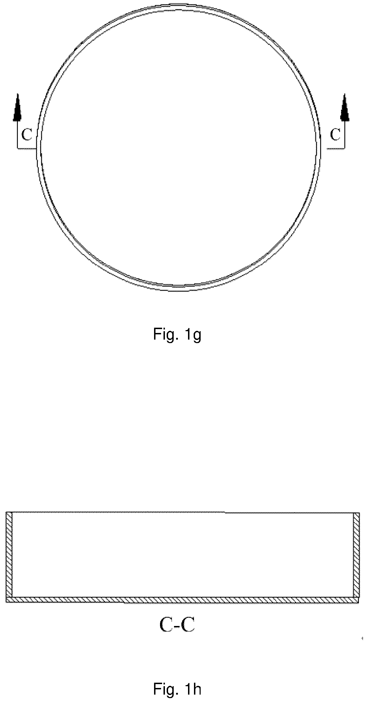

As shown in Figs. 1a-1h, a solid-state source gasification device compries a housing 1, a plurality of trays 2 and a carrier gas pipe 3. The housing 1 has a corrosion-resistant cavity, and a top cover 11 is provided at the top of the housing 1. When the top cover 11 is fixedly connected to the housing 1, a gas-tight cavity can be formed in the housing 1, and a gas inlet 12 and a gas outlet 13 are provided on the top cover 11. In the working state, the housing 1 is heated to a specific temperature, which causes a solid source to gasify to produce a vapour. The heating of the housing 1 can be realized by a heating device wrapped around the housing or by placing it in a liquid heating container, or by other heating devices.

The carrier gas pipe 3 has a tubular shape. An upper end of the carrier gas pipe 3 is connected to a gas inlet on the top cover of the housing, and the bottom of the carrier gas pipe extends into the bottommost-layer tray 2 within the housing 1. A carrier gas outlet 33 is provided on the carrier gas pipe 3, and the carrier gas outlet 33 is provided at a position corresponding to the internal space (The tray comprises a bottom wall and a side wall provided at an edge of the tray bottom wall, and the sapce formed between the bottom wall and the side wall.) of the several trays 2, so that the carrier gas can enter directly into the corresponding trays 2 through the carrier gas pipe 3. For example, the carrier gas outlet 33 is provided on the carrier gas pipe 3 at a position corresponding to the internal space of the bottommost-layer tray 2. In a preferred embodiment, the carrier gas outlet 33 can be provided in the internal spaces of any two or more trays 2, or in the internal sapce of each tray 2. In order to bring the carrier gas entering to the solid-state source gasification device to a desired temperature, the carrier gas of the carrier gas pipe 3 has been heated in advance to a desired temperature. The carrier gas pipe 3 is arranged in a position corresponding to the position of the gas inlet 12 on the top cover 11 of the housing 1. The carrier gas pipe 3 may or may not be designed in the middle of the tray 2.

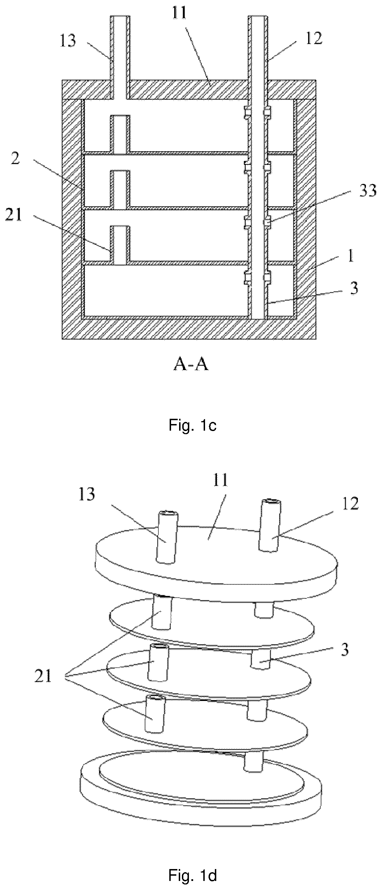

The tray 2 is designed for holding a solid source substance. The tray 2 comprises a bottom wall and a side wall provided at an edge of the bottom wall, and a sapce for holding the solid source material formed between the bottom wall and the side wall. The number of trays can be plual, for example, one, two, three or more trays arranged vertically. In order to increase the gasification rate of the solid source substance, a plurality of trays are usually provided within the solid-source gasification device. The plurality of trays are provided within the housing by means of vertical stacking. In this embodiment, there are four trays, and the four trays are stacked vertically in the housing. As shown in Fig. 1d and Fig. 1e, a plurality of through holes for passing through the carrier gas pipes 3 are provided on the bottom wall of the first-layer tray to third-layer tray, and a vertical gas conduit 21 is provided on the bottom wall of the trays. There are no through holes and gas conduits on forth-layer tray. In a preferred option, the gas conduit 21 can be arranged away from the carrier gas pipe 3. As shown in Fig. 1c, a distance between the gas conduit 21 and the carrier gas pipe 3 is greater than a distance between the carrier gas pipe 3 and the center position of the tray. The gas conduit 21 is used to transfer the mixed gas in a lower tray to an upper tray. In order to facilitate the vertical stacking of the multi-layer trays, the height of the gas conduit 21 should be lower than the height of the side wall of the tray. The number of gas conduits 21 and the aperture of the gas conduits 21 can be arranged according to the requirement of the transportation speed of the carrier gas, and a single gas conduit 21 can be provided, or two or more gas conduits 21 can be provided. In this embodiment, a single gas conduit 21 is provided on each of the first-layer tray to third-layer tray 2, and the gas conduit 21 is close to the gas outlet 13.

In this embodiment, the heated carrier gas outside the solid-state source gasification device enters into the carrier gas pipe 3 from the gas inlet 12 and enters into each tray 2 through the carrier gas outlet 33 on the carrier gas pipe 3 respectively. And the carrier gas which enters into the tray 2 moves along the surface of the solid-state source material in the tray 2 to the position where the gas conduit 21 is located. In the process, carrier gas can carry a large amount of the solid-state source vapor and increase the vapor content in the mixed gas, thereby increasing the volatilization efficiency of the solid source material. Because the gas conduits of each tray are directly opposite to each other, the mixed gas that enters from the lower tray into the upper tray through the gas conduit will quickly reach the upper tray, and the mixed gas will be transported at a faster rate.

### Example 2

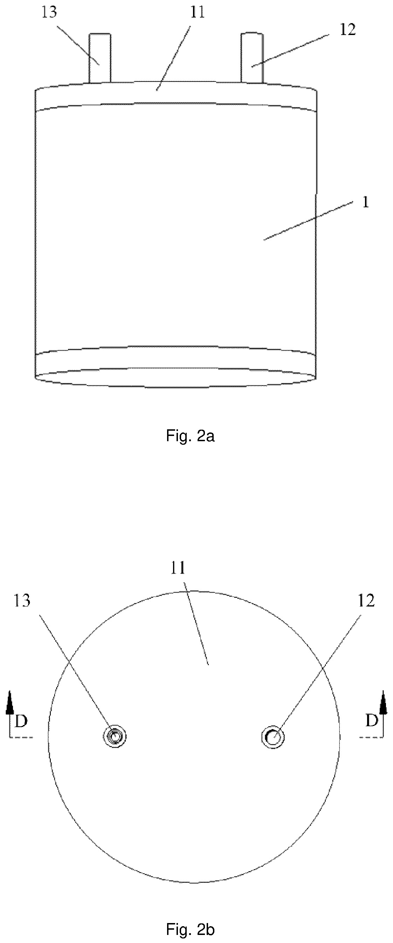

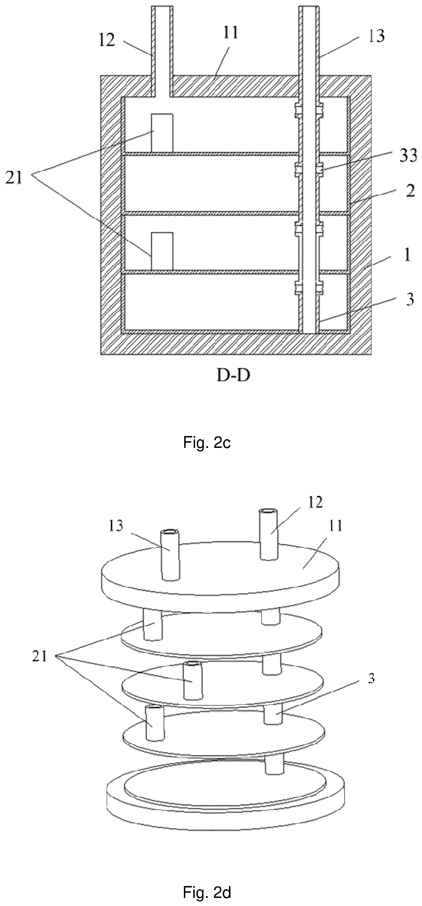

As shown in Figs. 2a-2d, a solid-state source gasification device differs from Example 1 in that the gas conduit 21 is designed to be located at a position away from the carrier gas pipe 3 within the first-layer tray to third-layer tray 2, and the gas conduits 21 within the neighboring trays 2 are staggered at a certain distance from each other. That is, the gas conduits 21 in adjacent trays 2 are staggered in a direction perpendicular to the bottom wall of the tray. And the position of the gas conduit 21 is staggered at a certain distance from the gas outlet 13 within each tray 2. As shown in the Figs.2a-2d, four trays 2 are provided in the housing 1, and there is no gas conduit in the fourth-layer tray. The gas conduits 21 in the first-layer tray and third-layer tray 2 are arranged near the gas outlet 13 and are in rearward position with respect to the gas outlet 13. The gas conduit 21 in the second-layer tray 2 is arranged near the gas outlet 13 and in forward position of the gas outlet 13.

In this embodiment, the carrier gas enters into the carrier gas pipe 3 from the carrier gas inlet 12 and enters into each tray 2 through the carrier gas outlet on the carrier gas pipe 3 respectively. And the carrier gas entering the tray 2 moves along the surface of the solid material in the tray 2 to the position where the gas conduit 21 is located. In the process, the carrier gas can carry a large amount of solid-source vapors, thereby increasing the content of vapors in the mixture and the volatilization efficiency of the solid-source material. Because the gas conduits 21 in the adjacent trays 2 are arranged at a staggered distance, and the position of the gas conduits 21 in each tray 2 is arranged at a staggered distance from the gas outlet 13, so that the mixed gas from the lower tray 2 passing through the gas conduits 21 and entering into the upper tray 2 has to pass through a certain distance before it can reach the gas conduits 21 in the upper tray 2 again. And thus, the mixing distance of the mixed gas in each tray 2 is increased that can make the output mixed gas mix more evenly.

### Example 3

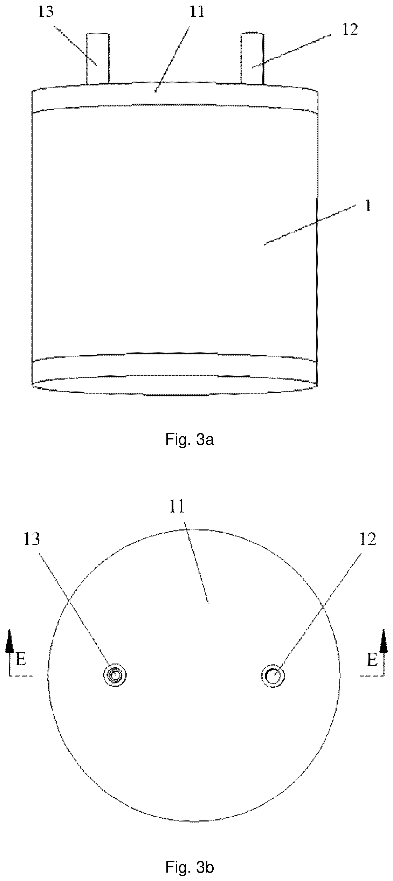

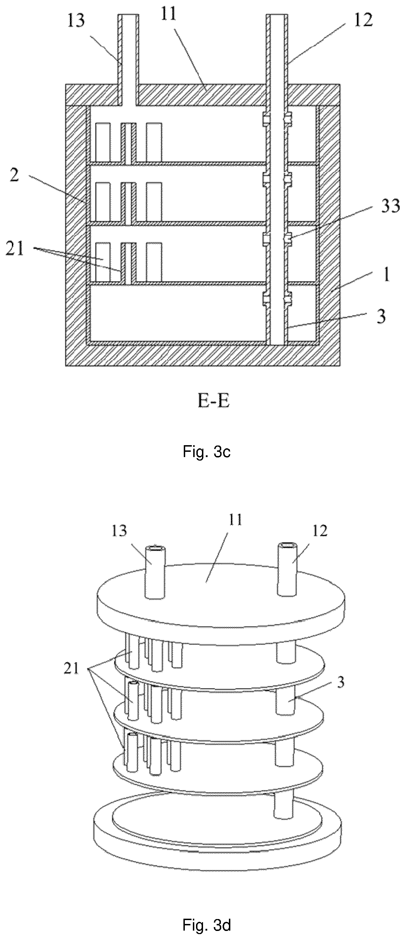

As shown in the Figs. 3a-3d, a solid-state source gasification device differs from the preceding Example 1 in that a plurality of gas conduits 21 are provided in each tray 2 except for the bottommost-layer tray, and the gas conduits 21 are arranged away from the carrier gas pipe.

In this embodiment, the carrier gas, after being heated on the outside of the solid-state source gasification device, enters into the carrier gas pipe 3 from the gas inlet 12 and enters into each tray 2 through each carrier gas outlet 33 on the carrier gas pipe 3. The carrier gas is transported within each tray 2 along the surface of the solid-state source substance in the trays 2 to the gas conduit 21 of the upper-layer tray 2. The carrier gas can carry a large amount of the solid-state source vapors during the process of the gas transmission, increasing the content of the vapors in the gas mixture, which in turn increases the volatilization efficiency of the solid source material. Because a plurality of gas conduits 21 are provided on the first-layer tray, the rising speed of the gas mixture can be accelerated, and the transmission efficiency of the volatilized gas can be increased.

### Example 4

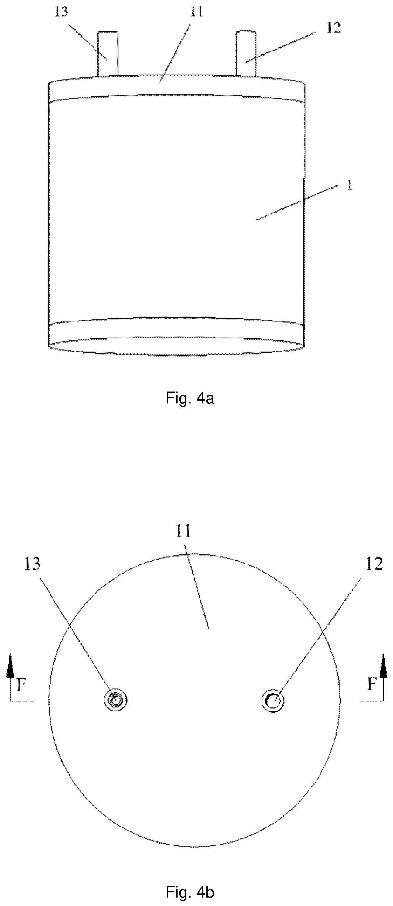

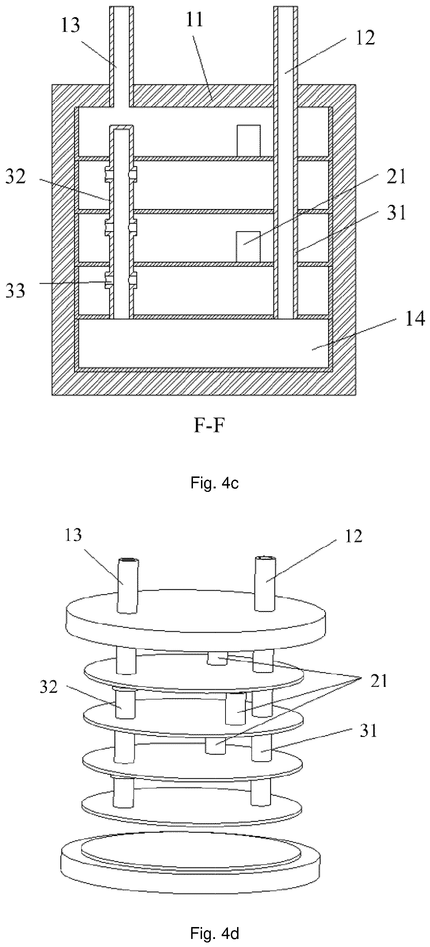

As shown in the Figs. 4a-4d, a solid-state source gasification device differs from the preceding Example 1 in that there are two carrier gas pipes. Which is named first carrier gas pipe 31 and second carrier gas pipe 32, respectively. The first carrier gas pipe 31 is not provided with a carrier gas outlet or with a gas outlet opening. The first gas carrier pipe 31 extends from the gas inlet 12 into the space 14 of the bottommost-layer tray 2 and is connected to the space 14. The gas conduits 21 are provided on the trays 2 except for the two lowermost-layer trays 2. And the gas conduits 21 in the adjacent trays 2 are staggered at a certain distance from one another, i.e., the adjacent trays 2 are staggered in the direction of perpendicularity to the bottom wall of the tray. The second carrier gas pipe 32 passes through each tray 2 except the uppermost-layer tray and bottommost-layer tray 2. The second carrier gas pipe 32 is provided with a carrier gas outlet 33, and the position of the gas conduit 21 and the second carrier gas pipe 32 may be designed according to the need. As a preferred embodiment, the gas conduit 21 may be arranged away from the second carrier gas pipe 32. For example, the gas conduit 21 is arranged near the first carrier gas pipe 31 and the second carrier gas pipe 32 is arranged away from the gas conduit 21, or the second carrier gas pipe 32 is arranged near the first carrier gas pipe 31 and the gas conduit 21 is arranged away from the second carrier gas pipe 32, or other gas conduits 21 are located away from the second carrier gas pipe 32.

As shown in Figs. 4a-4d, in this embodiment, five trays 2 are provided in the housing 1. There is no gas conduit in the fourth-layer tray and fifth-layer tray, and the gas conduits 21 in the first-layer tray and third-layer tray are arranged in the vicinity of the first carrier gas pipe in a rearward-side position. And the gas conduits in the second-layer tray are designed in the vicinity and a forward position of the first carrier gas pipe. In this case, a distance between the first carrier gas pipe 31 and the second carrier gas pipe 32 is greater than a distance between the first carrier gas pipe 31 and the center position of the tray. And a distance between the first carrier gas pipe 31 and the second carrier gas pipe 32 is greater than a distance between the second carrier gas pipe 32 and the center position of the tray 2. Also, a distance between the gas conduit 21 and the second carrier gas pipe 32 is greater than a distance between the second carrier gas pipe 32 and the center position of the tray.

In this embodiment, the carrier gas is transferred from the inlet 12 through the first carrier gas pipe 31 into the space 14 of the fifth-layer tray. Within the space 14, the carrier gas is transferred to the lower opening of the second carrier gas pipe 32 and then enters the second carrier gas pipe 32. And the carrier gas rises through the second carrier gas pipe 32 and enters the fourth-layer tray to the second-layer tray 2 through the respective carrier gas outlets 33 on the second carrier gas pipe 32. The carrier gas is transported over the surface of the solid substance in the tray 2 and reaches the position of the gas conduit 21 when it reaches the upper tray 2 through the gas conduit 21. Because the gas conduits 21 within the adjacent trays 2 are staggered and arranged at a certain distance from the first-layer tray to the third-layer tray. The gas mixture rises from the gas conduits 21 and then has to pass through a transmission distance before it rises again into the upper tray 2, which increases the mixing distance of the gases, and enables the gases to be mixed more uniformly. Because the second carrier gas pipe 32 does not enter directly into the first-layer tray 2, thus the carrier gas and the volatile gas experience the mixing in the second-layer tray before they can enter into the first-layer tray through the gas conduit 21 in the first-layer tray 2, which can make the mixing of the mixed gases more uniform.

### Example 5

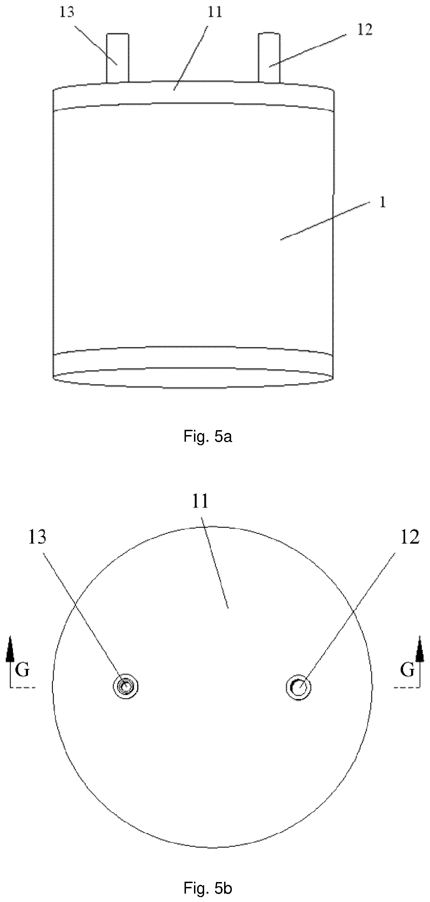

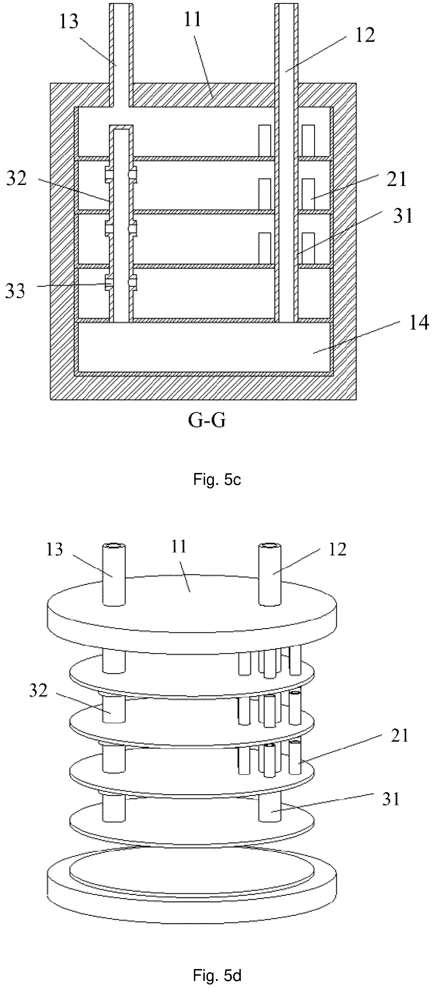

As shown in the Figs. 5a-5d, a solid-state source gasification device differs from Example 4 in that a plurality of gas conduits 21 are provided in each of the first-layer tray to the third-layer tray, with the gas conduits 21 being distributed in the vicinity of the first carrier gas pipe 31.

In this embodiment, the carrier gas is transferred from the gas inlet 12 through the first carrier gas pipe 31 into the space 14 of the bottommost-layer tray. Within the space 14, the carrier gas is transferred to the lower opening of the second carrier gas pipe 32 and then enters the second carrier gas pipe 32 . The carrier gas rises through the second carrier gas pipe 32 and enters the fourth-layer tray to the second-layer tray 2 through the respective carrier gas outlets 33 on the second carrier gas pipe 32. The carrier gas is transported over the surface of the solid substance in the tray 2 and reaches the position of the gas conduit 21 when it reaches the upper-layer tray 2 through the gas-guide coundit 21. Because a plurality of gas conduits 21 are provided from the first-layer tray to the third-layer tray, it can speed up the rising speed of the mixed gas and increase the transfer efficiency of the gasified gas.

### Example 6

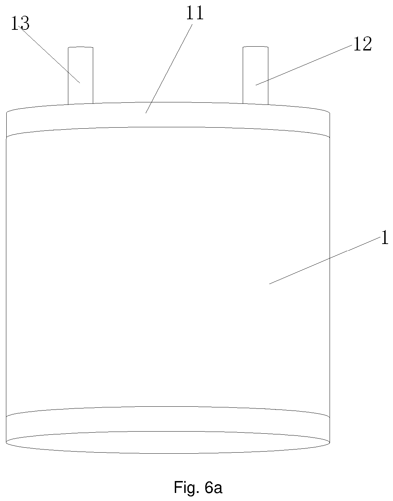

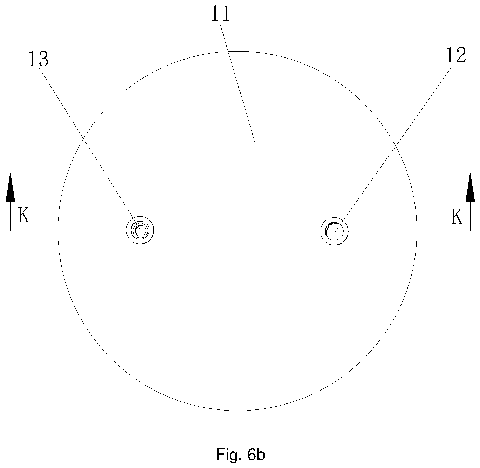

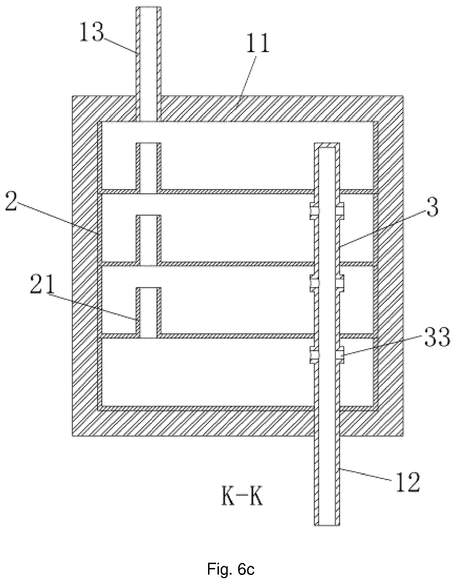

As shown in Figs. 6a-6c, a solid-state source gasification device differs from Example 1 in that the gas inlet 12 is arranged at the bottom of the housing 1, and the carrier gas pipe 3 passes through each tray sequentially from the bottom up from the gas inlet 12. The carrier gas pipe 3 does not have an opening at the upper end, and a carrier gas outlet 33 is provided in the carrier gas pipe 3. The carrier gas outlet 33 is provided at a position corresponding to the internal space of each tray 2 except the uppermost-layer tray 2.

In this embodiment, the heated carrier gas outside the solid-state source gasification device enters into the carrier gas pipe 3 from the gas inlet 12 at the bottom of the housing and enters into the trays 2 except for the uppermost tray 2 through the carrier gas outlet 33 on the carrier gas pipe 3, respectively. The carrier gas entering the trays 2 moves along the surface of the solid state material in the trays 2 to the position where the gas conduit is located. In the process, a large amount of vapors can be carried, increasing the content of vapors in the gas mixture and the gasification efficiency of the solid source material. Because the gas conduits of the layers are directly opposite each other, the gas mixture from within the lower tray that enters the upper tray through the gas conduits will quickly reach the upper tray, and the gas mixture will be transferred at a faster rate.

Although embodiments of the present invention have been shown and described, it will be understood to one of ordinary skill in the art that a wide variety of changes, modifications, substitutions, and variations may be made to these embodiments without departing from the principle and spirit of the present invention, the scope of which is limited by the appended claims and their equivalents.

## Claims

1. A solid-state source gasification device, comprising a housing and several layers of trays, wherein a top cover is provided on the top of the housing, a gas inlet and a gas outlet are provided on the top cover, the trays are vertically stacked in the housing, wherein
a carrier gas pipe is provided in the housing, an upper end of the carrier gas pipe is connected with the gas inlet, the carrier gas pipe penetrates through the trays and extends to the bottommost-layer tray, wherein one or more carrier gas outlets are provided in the carrier gas pipe, and carrier gas outlets are formed in a space of the bottommost-layer tray or formed in a space of the bottommost-layer tray and the rest trays, and one or more gas conduits are formed in all trays except the bottommost-layer tray.

2. A solid-state source gasification device according to claim 1, wherein the gas conduits are arranged away from the carrier gas pipe.

3. A solid-state source gasification device according to claim 1, wherein the carrier gas pipe is arranged off-center with respect to the tray.

4. A solid-state source gasification device according to claim 1, wherein the gas conduits in adjacent trays are spaced apart at a set distance.

5. A solid-state source gasification device according to claim 1, wherein each tray is provided with several gas conduits , and the gas conduits are arranged away from the carrier gas pipe.

6. A solid-state source gasification device, wherein it comprises a housing and several layers trays, a top cover is provided on the top of the housing, a gas outlet is provided on the top cover, the trays are vertically stacked in the housing, a gas inlet is provided at the bottom of the housing, a carrier gas pipe is provided in the housing, an upper end of the carrier gas pipe is connected with the gas inlet, the carrier gas pipe penetrates through the various layers trays and extends to the bottommost-layer tray, one or more carrier gas outlets are provided in the carrier gas pipe, and carrier gas outlets are formed in a space of the bottommost-layer tray or formed in a space of the bottommost-layer tray and the rest trays, and one or more gas conduits are formed in all trays except the bottommost-layer tray.

7. A solid-state source gasification device according to claim 6, wherein the gas conduits are arranged away from the carrier gas pipe.

8. A solid-state source gasification device according to claim 6, wherein the carrier gas pipe is arranged off-center with respect to the tray.

9. A solid-state source gasification device according to claim 6, wherein the gas conduits in adjacent trays are spaced apart at a set distance.

10. A solid-state source gasification device according to claim 6, wherein each tray is provided with several gas conduits , and the gas conduits are arranged away from the carrier gas pipe.

11. A solid-state source gasification device, comprising a housing and several layers of trays, wherein a top cover is provided on the top of the housing, a gas inlet and a gas outlet are provided on the top cover, the trays are vertically stacked in the housing, a first carrier gas pipe and a second carrier gas pipe are provided in the housing, the upper of the first carrier gas pipe is connected to a gas inlet, a first carrier gas pipe penetrates through the trays and extends into a space of the bottommost tray, there are several second carrier gas pipes, the second carrier gas pipes penetrates through the trays from the bottom upward, the lower openning of the second carrier gas pipe is arranged in the space under the bottommost tray, and there are one or more gas outlets provided in the second carrier gas pipes, the carrier gas outlets are provided in the space of the bottommost tray or in the spaces of the bottommost tray and the rest of the trays, and one or more gas conduits are formed in all trays except the bottommost tray.

12. A solid-state source gasification device according to claim 11, wherein the first carrier gas pipe is formed at a central position of the tray or arranged off-center with respect to the tray.

13. A solid-state source gasification device according to claim 11, wherein the second carrier gas pipe is formed at a central position of the tray or arranged off-center with respect to the tray.

14. A solid-state source gasification device according to claim 11, wherein the second carrier gas pipe is arranged away from the first carrier gas pipe.

15. A solid-state source gasification device according to claim 11, wherein the gas conduit is arranged away from the second carrier gas pipe.

16. A solid-state source gasification device according to claim 11, wherein the gas conduits in adjacent trays are spaced apart at a set distance.

17. A solid-state source gasification device according to claim 11, wherein the tray is provided with a plurality of gas conduits.

18. A solid-state source gasification device according to claim 11, wherein the tray is provided with a plurality of gas conduits and the gas conduits are provided in the vicinity of the first carrier gas pipe.

19. A solid-state source gasification device according to claim 11, wherein the first carrier gas pipe is also provided with gas outlet openings at corresponding positions in the spaces of the one or more trays.

20. A solid-state source gasification device according to any one of claims 11-19, wherein there is one or more the second carrier gas pipes.
